(19) Europäisches Patentamt
European Patent Office
Office européen des brevets

(11) EP 2 009 647 A1

(12) EUROPEAN PATENT APPLICATION
published in accordance with Art. 153(4) EPC

(43) Date of publication:
31.12.2008 Bulletin 2009/01

(51) Int Cl.:
H01C 7/02 (2006.01)       C23C 14/14 (2006.01)
C23C 14/34 (2006.01)      H01L 37/00 (2006.01)

(21) Application number: 07740027.3

(22) Date of filing: 28.03.2007

(86) International application number:
PCT/JP2007/056589

(87) International publication number:
WO 2007/114143 (11.10.2007 Gazette 2007/41)

(84) Designated Contracting States:
AT BE BG CH CY CZ DE DK EE ES FI FR GB GR
HU IE IS IT LI LT LU LV MC MT NL PL PT RO SE
SI SK TR
Designated Extension States:
AL BA HR MK RS

(30) Priority: 28.03.2006 JP 2006088415

(71) Applicants:
• Mitsui Mining & Smelting Co., Ltd
Tokyo 141-8584 (JP)
• TOHOKU UNIVERSITY
Sendai-shi
Miyagi 980-8577 (JP)

(72) Inventors:
• IKEDA, Makoto
Ageo-shi, Saitama 362-0021 (JP)

• WADA, Mitsuhiro
Ageo-shi, Saitama 362-0021 (JP)
• INOUE, Shinichi
Ageo-shi, Saitama 362-0021 (JP)
• ISSHIKI, Minoru
Sendai-shi, Miyagi 980-8577 (JP)
• LIM, Jae-Won
Sendai-shi, Miyagi 980-8577 (JP)
• BAE, Joon Woon
Sendai-shi, Miyagi 980-8577 (JP)

(74) Representative: Hall, Matthew Benjamin
Frank B. Dehn & Co.
St Bride's House
10 Salisbury Square
London
EC4Y 8JD (GB)

(54) **METHOD FOR FABRICATING THIN FILM SENSOR, THIN FILM SENSOR AND THIN FILM SENSOR MODULE**

(57) [Problems] It is an object to provide processes for the production of thin-film sensors whereby crystals are strongly oriented without cost-adding steps such as heating and variations in electrical properties are small among the obtainable products.

[Means for Resolution] A process of producing a thin-film sensor is a process of producing a thin-film sensor that include an insulating substrate and an electrical resistor which is made of a metal and is provided on the insulating substrate, the said process including a step of forming the electrical resistor by sputtering the metal while applying a negative direct-current voltage to the insulating substrate.

[Fig.1]

**Description**

TECHNICAL FIELD

The present invention relates to processes for the production of thin-film sensors, thin-film sensors and thin-film sensor modules.

BACKGROUND ART

Thin-film sensor modules are used in temperature sensors, flow sensors, specific heat sensors, thermal conductivity sensors, concentration sensors, liquid identification soncere, strain sensors, stress sensors, humidity sensors and the like to enable them to perform their function of measuring temperature, flow rate, specific heat, thermal conductivity, concentration, liquid type, strain, stress or humidity of objects or fluids. Thin-film sensor modules having electrical resistors are widely used. They convert changes in amount of heat, flow rate, specific heat, thermal conductivity, concentration, liquid type, strain, stress or humidity into electric signals and detect temperatures. From the viewpoint of sensitivity in particular, thin-film sensor modules that have platinum elements with a large absolute value of temperature coefficient of resistance are common. However, enhanced resistivity is still needed.

As generally known in the art, the temperature coefficients of resistance of resistors change depending on the existence form of crystals forming the resistors (Non-patent Document 1). For example, Patent Document 1 and Non-patent Document 2 disclose techniques wherein a laminate of formed films is heat treated to increase the diameter of crystal grains forming the resistor and thereby to increase the sensitivity.

To increase the diameter of crystal grains forming an electrical resistor, a temperature-sensitive resistor such as platinum maybe deposited patternwise on a substrate by plating or deposition and be thereafter heat treated at approximately several hundred to a thousand degrees Celsius to grow the crystal.

Although higher sensitivity may be achieved by growing the crystal under severe heating conditions, such treatment entails a large amount of heat. In addition, facilities capable of enduring such amount of heat are necessary, which adds costs. Furthermore, the thermal load limits the selection of materials and designs, and increases surface roughness and causes nonuniform product quality and low production stability.

Patent Document 2 teaches that a layer of (for example) titanium is provided between a platinum thin film and a substrate in the production of platinum thin-film resistors to increase the adhesion therebetween.

In the production of platinum thin-film resistors according to Patent Document 1, a titanium layer is provided between a platinum thin film and a substrate to increase the adhesion of the platinum thin film with the substrate, and oxygen is mixed in a sputtering gas for the formation of the platinum thin film or the titanium layer so that annealing may be performed at high temperatures to increase sufficiently the temperature coefficient of resistance of the platinum thin film.

However, the adhesion between the platinum thin film and the substrate is still insufficient.

Patent Document 1: JP-A-2001-291607

Patent Document 2: JP-A-H11-354302

Non-patent Document 1: HAKUMAKU, BIRYUUSHI NO KOUZOU TO BUSSEI (thin films, structures of fine particles and properties), MARUZEN, pp. 139-156 (1974)

Non-patent Document 2: KOU TCR HAKKIN HAKUMAKU NO KAIHATSU (development of high TCR platinum thin films) IEEE Trans. SM., vol. 124, No. 7, pp. 242-247 (2004)

DISCLOSURE OF THE INVENTION

The present invention has been made in view of the above problems. It is therefore an object of the invention to provide processes for the production of thin-film sensors whereby crystals are strongly oriented without cost-adding steps such as heating and variations in electrical properties are small among the obtainable products.

Other objects of the invention are to provide processes for producing thin-film sensors which have high sensitivity and in which an electrical resistor is resistant to separation, and to provide thin-film sensors manufactured by the processes and thin-film sensor modules having the thin-film sensors.

SUMMARY OF THE INVENTION

A process of producing a thin-film sensor according to the present invention is a process of producing a thin-film sensor that comprises an insulating substrate and an electrical resistor which is made of a metal and is provided on the insulating substrate,
the said process comprising a step of forming the electrical resistor by sputtering the metal while applying a negative direct-current voltage to the insulating substrate.

The absolute value of the negative direct-current voltage is preferably from 25 V to 150 V.

The process of producing a thin-film sensor may not include a step of heating the electrical resistor.

The metal may be based on at least one metal selected from the group consisting of ruthenium, rhodium, palladium, osmium, iridium and Platinum.

The metal forming the electrical resistor preferably has a crystal grain diameter of not less than 0.2 $\mu$m, and the electrical resistor preferably has a surface roughness Ra of not more than 10 nm.

The thin-film sensor preferably further comprises an adhesion layer between the insulating substrate and the electrical resistor, the adhesion layer comprising a material based on a transition metal.

The thin-film sensor preferably further comprises a silicon compound layer between the insulating substrate and the adhesion layer, the silicon compound layer comprising a compound comprising silicon and an element selected from the group consisting of carbon, nitrogen, fluorine and oxygen.

The thin-film sensor may be a sensor selected from the group consisting of a temperature sensor, a flow sensor, a specific heat sensor, a thermal conductivity sensor, a concentration sensor, a liquid identification sensor, a strain sensor, a stress sensor and a humidity sensor.

A thin-film sensor according to the present invention is manufactured by the above process of producing thin-film sensor.

A thin-film sensor module according to the present invention comprises the above thin-film sensor.

ADVANTAGES OF THE INVENTION

The thin-film sensors according to the present invention ensure electrical properties, are producible at advantageous costs and have small variations in electrical properties among the sensors.

According to an aspect of the present invention, there may be provided processes for producing thin-film sensors which have high sensitivity and in which an electrical resistor is resistant to separation, thin-film sensors manufactured by the processes, and thin-film sensor modules having the thin-film sensors.

BRIEF DESCRIPTION OF THE DRAWINGS

Fig. 1 is a schematic view of a thin-film sensor (thin-film chip) according to an embodiment of the present invention.
Fig. 2 is a schematic view of a thin-film sensor (thin-film chip) according to an embodiment of the present invention.
Fig. 3 is a schematic view showing a thin-film sensor module according to an embodiment of the present invention.
Fig. 4 is a set of schematic sectional views illustrating a thin-film sensor module according to an embodiment of the present invention, wherein (a) is a longitudinal sectional plane view and (b) is a longitudinal sectional side view.

DESCRIPTION OF NUMERALS

10   thin-film sensor (thin-film chip)
11   insulating substrate
12   silicon compound layer
13   adhesion layer
14   electrical resistor
16   protective layer
18   bonding pad
20   thin-film sensor module
22   housing
24   fin plate
26   output terminal
32   bonding wire
34   first large-diameter part
36   second large-diameter part
38   notch

BEST MODE FOR CARRYING OUT THE INVENTION

<Thin-film sensors>

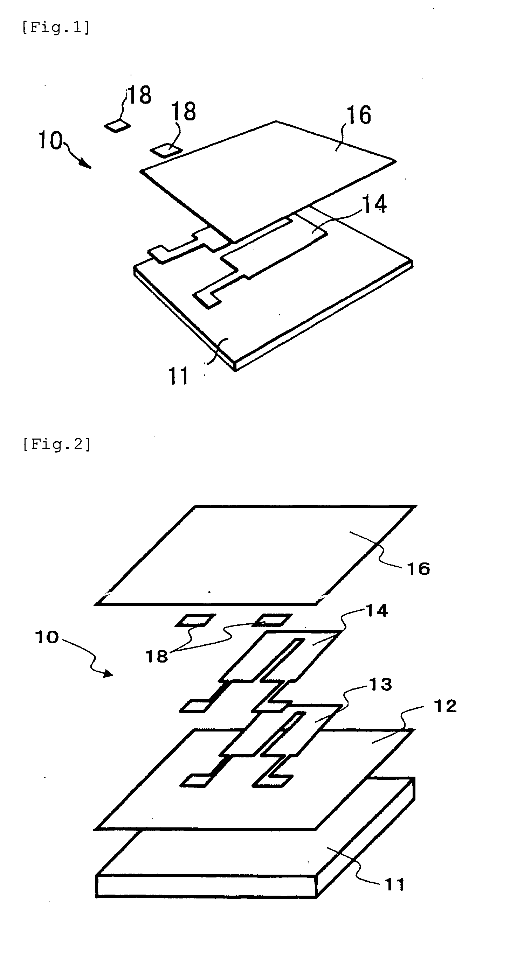

Fig. 1 is a schematic view of a thin-film sensor (thin-film chip) according to an embodiment of the present invention. A thin-film sensor 10 has at least an insulating substrate 11 having electric insulating properties and an electrical resistor 14.

Referring to Fig. 2, the thin-film sensor 10 may have an adhesion layer 13 between the insulating substrate 11 and the electrical resistor 14 and may further contain a silicon compound layer 12 between the insulating layer 11 and the adhesion layer 13 to increase the adhesion between the insulating substrate 11 and the electrical resistor 14. The thin-film sensor 10 may have a protective layer 16 on a surface of the thin-film sensor 10 to prevent physical damages of the thin-film sensor. The thin-film sensor 10 may have a bonding pad 18 that electrically connects the thin-film sensor 10 and an outside member.

In the invention, the direction extending from the insulating substrate to the electrical resistor may be defined as "upward" for convenience.

The insulating substrate 11 may be made of any insulating material without limitation. Exemplary materials include silicon and alumina. The insulating substrate 11 may have various shapes. It may be rectangular as shown in Fig. 1, or may be elliptical or circular. The insulating substrate 11 may have a thickness of approximately 300 to 1,000 $\mu$m.

The electrical resistor 14 is not particularly limited as long as it is made of a material that changes resistance in response to changes in index such as temperature or flow rate detected by the thin-film sensor in the invention. Examples of the materials for the electrical resistors 14 include transition metals such as platinum group metals, iron, nickel-cobalt and copper. When the thin-film sensor is used as a temperature sensor, an electrical resistor 14 for use may be made of a metal based on at least one metal selected from platinum group metals (ruthenium, rhodium, palladium, osmium, iridium and platinum) or may be made of an alloy of these metals. In particular, platinum is more preferred in view of easiness in film production, stability of properties, and cost. The electrical resistor 14 may be formed of the above material in a desired pattern with a desired thickness, for example about 0.1 to 1 $\mu$m.

A material for the adhesion layer 13 may be selected from materials that do not influence the temperature-resistance properties of the insulating substrate 11, such that these adverse effects will not be caused. Examples include materials that are based on a transition metal and may contain a metal other than the transition metal. The materials based on a transition metal include titanium (Ti), chromium (Cr), $TiO_2$ and TiBaO, with titanium and chromium being preferred in view of adhesion. The materials based on transition metals generally contain transition metals at 10 to 100 wt%, and preferably 60 to 100 wt%. The thickness of the adhesion layer is preferably 0.002 to 0.1 $\mu$m, and more preferably 0.005 to 0.05 $\mu$m.

The silicon compound layer 12 comprises a compound comprising silicon and an element selected from the group consisting of carbon, nitrogen, fluorine and oxygen. Examples of such compounds include $SiO_2$, SiN, SiON, SiC, SiOC and SiOF, with $SiO_2$ being preferred in view of easy film production.

The silicon compound layer 12 preferably has a thickness of 50 to 5,000 nm, and more preferably 100 to 1,000 nm.

The electrical resistor 14 may be firmly bonded to the insulating substrate 11 with the adhesion layer 13 and the silicon compound layer 12 in between and will not separate from the insulating substrate 11.

The protective layer 16 may be made of any material without limitation as long as the above-mentioned objects are achieved. Exemplary materials are resins and glasses. The protective layer 16 may be approximately 1 $\mu$m in thickness.

The bonding pad 18 may be made of any material without limitation as long as it has good electrical conductivity. Exemplary materials are gold (Au) and platinum. The bonding pad 18 may have various shapes depending on application. For example, it may be approximately 0.2 mm in length, 0.15 mm in width and 0.1 $\mu$m in thickness.

The thin-film sensors according to the present invention may be used in apparatuses for measuring an index that influences the resistance value of the electrical resistor. Examples of the apparatuses include temperature sensors, flow sensors, specific heat sensors, thermal conductivity sensors, concentration sensors, liquid identification sensors, strain sensors, stress sensors and humidity sensors.

<Existence Form of crystal in electrical resistor>

In the thin-film sensor according to the invention, a crystal forming the electrical resistor has a specific orientation. In the invention, the orientation is defined as the orientation properties described below. The orientation properties indicate a percentage of (111) planes of crystals oriented at not more than 10° from the normal direction (ND direction) in a layer of the electrical resistor (i.e., crystals forming the electrical resistor). In the thin-film sensor of the invention, the percentage is preferably not less than 90%. The value of the "orientation properties" is a value determined by the method described in Examples later.

It is generally known that the crystalline form in electrical resistors determines how the resistance value will change with temperature increase of the electrical resistors. The gradient of temperature coefficient of resistance is known to become sharp with change in crystalline form, in particular with increase of crystal grain diameters. Increasing grain diameters is a common method for improving the sensitivity of thin-film sensors.

The present invention focuses on the forms of crystals forming electrical resistors. In detail, the present inventors have found that the temperature coefficient of resistance of electrical resistors is increased by controlling the crystalline form, in particular the orientation properties of the crystal. It is not known exactly why controlling the orientation properties improves the temperature coefficient of resistance, but one reason is probably that electrical properties of the crystal are enhanced by orienting the crystal in a specific direction.

In a preferred embodiment, the crystal forming the electrical resistor has a fiber-like orientation texture and (111) planes of the crystals in the fiber-like orientation texture have axis of rotation that are vertical to a layer of the electrical resistor. According to this preferred embodiment, electrical properties are enhanced. The fiber-like orientation texture may be observed by various methods used for the observation of such textures, and may be observed with an EBSD apparatus as described below.

In the invention, the orientation properties of crystals were determined by EBSD (Electron Backscatter Diffraction Pattern) method. X-Ray diffractometers (XRD) are generally used for the determination of crystal orientation of inorganic materials. However, the diffractometers only provide average information on the entire crystal structure and do not evaluate the form of individual crystal grains forming the crystal structure. Transmission electron microscopes (TEM) are commonly used to determine the orientation of individual crystal grains. However, it is practically impossible to evaluate statistically the crystal grains in the crystal structure.

On the other hand, EBSD apparatuses quickly determine the form of individual crystal grains and enable the determination of crystal grain diameters or grain size distribution and the evaluation of crystal orientation or strain calculation.

In the thin-film sensors of the invention, the electrical resistor preferably has a surface roughness (Ra) of not more than 10 nm, and more preferably not more than 5 nm. The lower limit of this surface roughness is not particularly limited, but is generally about 1 nm. The surface roughness (Rz) is preferably not more than 1.0 $\mu$m, and more preferably not more than 0.5 $\mu$m. The lower limit of this surface roughness is not particularly limited, but is generally about 0.1 $\mu$m. If these parameters are outside the above ranges, the electrical resistors that are formed patternwise may not have stable electrical properties and the productivity may be lowered.

The crystal forming the electrical resistor preferably has a grain diameter of not less than 0.2 $\mu$m, and more preferably not less than 0.4 $\mu$m. The upper limit of the grain diameter is not particularly limited, but is generally about 5.0 $\mu$m. The value of the crystal grain diameter is a value determined by a method described in Examples later.

The thin-film sensor preferably has a temperature coefficient of resistance of not less than 3,000 ppm/K, and more preferably not less than 3,300 ppm/K. The upper limit is about 3,900 ppm/K.

<Methods for producing thin-film sensors>

In a method for producing thin-film sensors according to the present invention, the electrical resistor is formed on the insulating substrate by sputtering.

The sputtering is performed while applying a negative direct-current bias voltage to the insulating substrate. The absolute value of the voltage is preferably from 25 V to 150 V, more preferably from more than 50 V to less than 150 V, and particularly preferably from 75 V to 125 V. If the absolute value is outside this range, film-forming properties will not be practical and the obtainable thin-film sensors will not have practical electrical properties such as TCR.

By changing the negative direct-current bias voltage, TCR of the electrical resistor may be controlled. The reason for this effect is not known exactly but may be as follows.

(1) Raising the bias voltage increases the energy of the sputtered particles, and therefore the particles that are incident on the substrate can reach an energetically stable site. Consequently, the particles form a dense layer (electrical resistor) in which the particles have large crystal grain diameters and are highly oriented.
(2) As a result of (1), the diffusion of impurities (in particular, Ti found in the adhesion layer) is prevented, and TCR of the electrical resistor is increased.

Conditions such as degree of vacuum and pressure in the sputtering are not particularly limited.

In the sputtering, an inert gas such as argon may contain oxygen gas. The amount of oxygen mixed with the inert gas may be in the range of 0.5 to 30% by volume at standard state, and preferably in the range of 2 to 20% by volume. If the amount is less than 0.5% by volume, part of the metal atoms forming the adhesion layer will diffuse into the electrical resistor and thereby the temperature coefficient of resistance (TCR) of the resistor will be lowered. At more than 30% by volume, the oxygen will dissolve in the crystal forming the electrical resistor and thereby the temperature coefficient of resistance (TCR) will be lowered.

For the production of thin platinum films as electrical resistors, deposition may be carried out under the following conditions.

Apparatus: RF sputtering apparatus
Interelectrode distance: 20 to 60 mm
Ultimate vacuum: not more than 3.0 x $10^{-4}$ Pa
Film-forming pressure: 4 to 12 Pa
Film-forming electrical power: 180 to 250 W
Film-forming temperature: room temperature to 80°C

To prevent oxygen from dissolving or being incorporated as impurities in the crystal forming the electrical resistors thereby to reduce the temperature coefficient of resistance (TCR) of the electrical resistors, the electrical resistors are preferably sputtered consecutively without contact with air, oxygen or water.

When the adhesion layer is provided in a laminate or the thin-film sensor comprising the laminate of the invention, the adhesion layer may be deposited on the insulating substrate by methods such as sputtering prior to the formation of the electrical resistor, and thereafter the electrical resistor may be formed as described above. The production of the adhesion layer is preferably followed by the subsequent steps without contact with air, oxygen or water. Production conditions for the adhesion layer are not particularly limited and may be selected appropriately in accordance with the conditions for the subsequent production of the electrical resistor. For the production of titanium (Ti) layers as the adhesion layer, deposition may be carried out under the following conditions.

Deposition method: sputtering
Apparatus: magnetron sputtering apparatus
Ultimate vacuum: not more than 6.0 x $10^{-5}$ Pa
Film-forming pressure: 0.1 to 2 Pa
Gas flow rate: 10 to 180 SCCM
Film-forming electrical power: 400 to 1,400 W
Film-forming temperature: room temperature to 250°C

When the silicon compound layer is provided in the thin-film sensor, the silicon compound layer is formed on a surface of the insulating substrate prior to the formation of the adhesion layer.

The silicon compound layer may be formed by methods such as sol-gel methods, spin coating, CVD and sputtering. Exemplary production conditions are as follows.

Lamination method: spin coating
Apparatus: spin coater
Material: $SiO_2$ film-forming coating material (SOG)
Rotations: 1,000 to 6,000 rpm
Temperature: 450 to 1,000°C

The multilayer structure (including the insulating substrate, the electrical resistor, optionally the adhesion layer and optionally the silicon compound layer) is annealed at 900 to 1,100°C to give a thin-film sensor.

If the annealing temperature is less than 900°C, the obtainable thin-film sensor tends to have a low temperature coefficient of resistance. Annealing at above 1, 100°C tends to deteriorate the surface condition of the thin-film sensor. The annealing time may be, for example, in the range of 4 hours to less than 8 hours. If the annealing time is less than 4 hours, that is, if the annealing time is excessively short the electrical resistor will greatly change the resistance value with time. If the annealing time is more than 8 hours, the platinum crystal grains grow excessively in size to increase the surface roughness, and the uniformity in the plate tends to be reduced.

The electrical resistor may be patterned to various shapes by etching or the like. For example, the electrical resistor may be shaped to a meandering pattern with a width of 5 to 25μ m and a total length of 4 to 23 cm by etching or the like.

<Thin-film sensor modules>

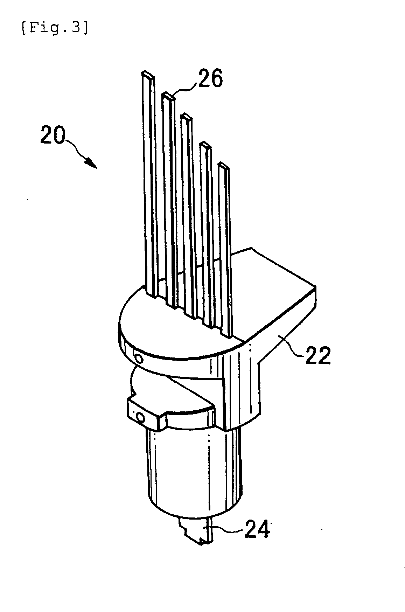

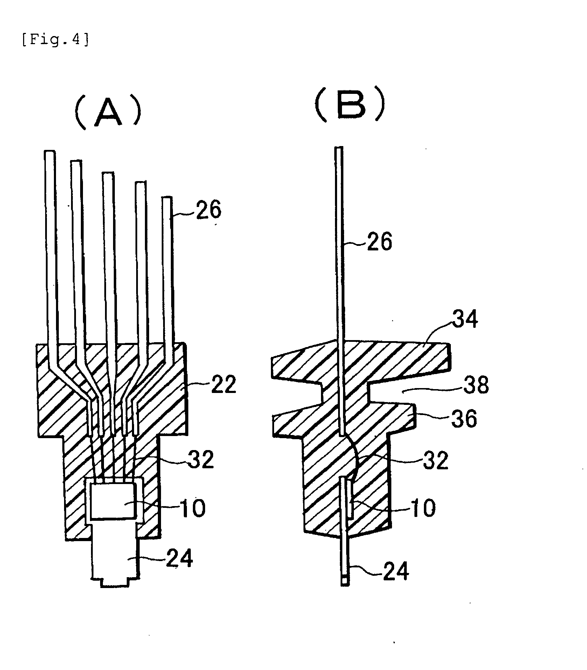

The thin-film sensor modules according to the present invention will be described. The thin-film sensor module of the invention has a member that is thermally connected with a sample object or fluid, the above-described thin-film sensor that is thermally connected with the member, and a member that is electrically connected with the thin-film sensor. This constitution is illustrated in Figs. 3 and 4.

Fig. 3 is a schematic view showing a thin-film sensor module (for example, a temperature sensor module) according to an embodiment of the present invention. Fig. 4 is a set of schematic sectional views illustrating a thin-film sensor module (for example, a temperature sensor module) according to an embodiment of the present invention, wherein (a) is a longitudinal sectional plane view and (b) is a longitudinal sectional side view. A thin-film sensor module (for example, a temperature sensor module) 20 of the invention has and a thin-film sensor (for example, a temperature sensor) 10 to which a fin plate 24 and output terminals 26 are firmly bonded inside a housing 22.

The housing 22 may be made of any material having low thermal conductivity. Materials resistant to chemicals or oils may be used depending on the type of the sample object or fluid. Examples of the materials having these properties include epoxy resins, polybutylene terephthalate (PBT) and polyphenylene sulfide (PPS). The thin-film sensor module may have various shapes depending on the application of the thin-film sensor module. For example, the housing 22 as shown in Figs. 3 and 4 (B) has a first large-diameter part 34 from which the output terminals 26 protrude, and a second large-diameter part 36 below the first large-diameter part 34 with a spacing therebetween; and may have a notch 38 that provides a heat insulating space between the first large-diameter part 34 and the second large-diameter part 36. The shape of the housing 22 is not limited to that described above.

The fin plate 24 may be made of any material without limitation as long as it has good thermal conductivity. Examples of the materials include copper, aluminum, tungsten, duralumin and copper-tungsten alloy. The fin plate 24 may have various shapes depending on the application of the thin-film sensor module. For example, it may be a thin plate having a thickness of approximately 200 $\mu$m. The fin plate 24 and the thin-film sensor 10 may be firmly bonded together with any thermally conductive material such as silver paste.

The output terminals 26 may be made of any material without limitation as long as the material has electrical conductivity. Examples of the materials include copper and aluminum. The output terminals 26 may be electrically connected to the thin-film sensor 10 via bonding wires 32. In Fig. 3, the output terminals 26 extending from the resin housing 2 are arranged in a straight line and gradually increase (or gradually reduce) the length in which they extend from the resin housing 2 from one end to the other of the straight line. However, the output terminals 26 may have various shapes depending on application. The shape shown in Fig. 3 permits easy attachment of a sensor pressing plate that presses downward the thin-film sensor module 20, or a flow rate-detecting circuit board that forms a circuit by being connected with the output terminals 26. The shape shown in the figure also reduces the probability that the thin-film sensor module 20 will be damaged during the attaching of the sensor pressing plate or the flow rate-detecting circuit board.

[EXAMPLES]

The present invention will be described by EXAMPLES below without limiting the scope of the invention.

(Comparative Example 1)

A SiO$_2$ layer with a thickness of 300 nm was formed on an alumina substrate (a circular disk 100 mm in diameter and 385 $\mu$m in thickness) by spin coating under the following conditions.
[0069]

　　Apparatus: spin coater
　　Material: SiO$_2$ film-forming coating material
　　(Material: OCD (trade name),
　　siloxane-based material, manufactured by TOKYO OHKA KOGYO CO., LTD.)
　　Rotations: 1,000 rpm x 5 s → 5,000 rpm x 30 s
　　Temperature: 695°C

On the SiO$_2$ layer thus formed, a titanium layer having a thickness of 30 nm was formed bv sputtering using metal titanium (99.99% purity) as the target under the following conditions.
[0071]

　　Apparatus: magnetron sputtering apparatus
　　Ultimate vacuum: less than 6.0 x 10$^{-5}$ Pa

Film-forming pressure: 0.86 Pa
Gas flow rate: 180 SCCM [Ar:$O_2$ = 10:0 (volume ratio at standard state)]
Film-forming electrical power: 1,000 W (DC)
Film-forming temperature: 250°C

On the titanium layer, an electrical resistor having a thickness of 400 nm was formed by sputtering using platinum (99.9% purity) as the target under the following conditions.
Apparatus: magnetron sputtering apparatus
Ultimate vacuum: less than 6.0 x $10^{-5}$ Pa
Film-forming pressure: 0.18 Pa
Gas flow rate: 10 SCCM [Ar:$O_2$ = 9:1 (volume ratio at standard state)]
Film-forming electrical power: 500 W (RF)
Film-forming temperature: 250°C

The thin-film sensor 1 produced as described above was tested for temperature coefficient of resistance (TCR), crystal grain diameters, orientation properties, adhesion, Ra and Rz as described later. The results are set forth in Table 1.

(Example 1)

A $SiO_2$ layer and a titanium layer were formed on an alumina substrate in the same manner as in Comparative Example 1. On the titanium layer, an electrical resistor having a thickness of 400 nm was formed by sputtering using platinum (99.9% purity) as the target under the following conditions. A thin-film sensor 2 was thus manufactured.
Apparatus: RF sputtering apparatus
Interelectrode distance: 35 mm
Target diameter: 7.5 mm
Ultimate vacuum: less than 3.0 x $10^{-5}$ Pa
Film-forming pressure: 9 Pa
Direct-current voltage applied to substrate: -100 V
Film-forming electrical power: 220 W (RF)
Film-forming temperature: 80°C

The thin-film sensor 2 produced as described above was tested for temperature coefficient of resistance (TCR), crystal grain diameters, orientation properties, adhesion, Ra and Rz as described later. The results are set forth in Table 1.

(Example 2)

A thin-film sensor 3 was produced in the same manner as in Example 1 except that the direct-current voltage in Example 1 was changed to -50 V. The thin-film sensor 3 was tested for temperature coefficient of resistance (TCR), crystal grain diameters, orientation properties, adhesion, Ra and Rz as described later. The results are set forth in Table 1.

(Comparative Example 2)

The thin-film sensor 1 produced in Comparative Example 1 was heat treated at 1,000°C for 4 hours in an air atmosphere to give a thin-film sensor 4. The thin-film sensor 4 was tested for temperature coefficient of resistance (TCR), crystal grain diameters, orientation properties, adhesion, Ra and Rz as described later. The results are set forth in Table 1.

<Measurement of temperature coefficient of resistance (TCR)>

The thin-film sensor was tested for specific electric resistance p at varied temperatures, and the temperature coefficient of resistance (TCR) was obtained from the results.
In the invention, the temperature coefficient of resistance is expressed by Formula 1 below.
$$\text{Formula 1: } \alpha = (1/R) \times (dR/dT) \times 10^6$$

α: temperature coefficient of resistance (ppm/°C)
T: arbitrary absolute temperature (K)
R: zero-power resistance (Ω) at T (K)

<Crystal grain diameters>

A longitudinal section of the thin-film sensor was smoothed by polishing and with focused ion beam (FIB). With respect to the smoothed longitudinal section, image data of the crystal pattern was obtained by EBSD method by means of a scanning electron microscope (JSM-6700F or JSM-7000F manufactured by JEOL Ltd.) that had a FE gun and was equipped with an EBSD apparatus (OIM Analysis, manufactured by TSL Solutions) and also by means of the supplied EBSD analyzer. The image data was analyzed while selecting "Grain Size" from the analysis menu of an EBSD analysis program (OIM Analysis, the same as above), and the grain diameters (μm) of crystal grains having a crystal rotation angle of 5° or more were measured. In the determination of the crystal grain diameters, Σ3 grain boundaries indicating twin boundaries were considered as intragranular defects.

<Orientation properties>

A longitudianal section of the thin-film sensor was smoothed by polishing and with focused ion beam (FIB). With respect to the smoothed longitudinal section, image data of the crystal pattern was obtained by EBSD method by means of a scanning electron microscope (JSM-6700F or JSM-7000F manufactured by JEOL Ltd.) that had a FE gun and was equipped with an EBSD apparatus (OIM Analysis, manufactured by TSL Solutions) and also by means of the supplied EBSD analyzer. The image data was analyzed while selecting "Crystal Direction" from the analysis menu of an EBSD analysis program (OIM Analysis, the same as above), under conditions such that the percentage relative to the total crystal grains was obtained of crystal grains wherein the plane direction of (111) planes of the platinum crystal of the electrical resistor was misaligned by not more than 10 degrees from the normal direction (ND) of the multilayer structure or the thin-film sensor. The percentage was defined as the orientation properties. Crystal grains having a crystal rotation angle of 5° or more were recognized to have crystal boundaries with each other, and crystal grains having a crystal rotation angle of less than 5° were collectively recognized as one crystal grain.

<Measurement of surface roughness Ra and Rz>

The surface roughness Ra and Rz of the thin-film sensor were measured with an optical interferometric three-dimensional structural analysis microscope (New View 5032, manufactured by Zygo Corporation). An area 54 x 72 μm in size was observed with a x100 Mirau lens using white light. The surface roughness Ra and Rz were determined from the three-dimensional image of the observed surface.

<Adhesion>

The thin-film sensor was tested for adhesion between the insulating substrate and the electrical resistor by the following wire pull test.

Wire pull test procedures

A gold wire (25 μm in diameter) was bonded to the gold electrode pad (18) of the thin-film chip (thin-film sensor). The gold wire was pulled with a load of about 10 g in the vertical direction relative to the thin-film chip at room temperature. The evaluation criteria were as follows.
AA: The gold electrode pad and the electrical resistor were not peeled from the gold wire, and the gold wire was broken.
CC: The gold electrode pad and the electrical resistor were peeled from the gold wire.
[Table 1]

[Table 1]

| | TCR (ppm/K) | Crystal grain diameter (μm) | Orientation properties | Surface roughness | | Adhesion |
|---|---|---|---|---|---|---|
| | | | | Ra (nm) | Rz (nm) | |
| Comp. Ex. 1 | 2,500 | 0.08 | 23 | 2.7 | 171.5 | AA |
| Ex. 1 | 3,010 | 0.21 | 99 | 5.1 | 420.0 | AA |
| Ex. 2 | 2,442 | 0.23 | 98 | 6.8 | 426.1 | AA |
| Comp. Ex. 2 | 3,356 | 0.32 | 96 | 166.7 | 1,800.0 | AA |

Preferred embodiments of the present invention are described hereinabove. Although some specific embodiments are discussed above, it will be apparent that various modifications and alterations are possible without departing from the scope and spirit of the invention defined in the claims. It should not be understood that the invention is limited to the specific embodiments and the attached drawings.

**Claims**

1. A process of producing a thin-film sensor that comprises an insulating substrate and an electrical resistor which is made of a metal and is provided on the insulating substrate, the said process comprising a step of forming the electrical resistor by sputtering the metal while applying a negative direct-current voltage to the insulating substrate.

2. The process of producing a thin-film sensor according to claim 1, wherein the absolute value of the negative direct-current voltage is from 25 V to 150 V.

3. The process of producing a thin-film sensor according to claim 1 or 2, wherein the process does not include a step of heating the electrical resistor.

4. The process of producing a thin-film sensor according to any one of claims 1 to 3, wherein the metal is based on at least one metal selected from the group consisting of ruthenium, rhodium, palladium, osmium, iridium and platinum.

5. The process of producing a thin-film sensor according to any one of claims 1 to 4, wherein the metal forming the electrical resistor has a crystal grain diameter of not less than 0.2 μm, and the electrical resistor has a surface roughness Ra of not more than 10 nm.

6. The process of producing a thin-film sensor according to any one of claims 1 to 5, wherein the thin-film sensor further comprises an adhesion layer between the insulating substrate and the electrical resistor, the adhesion layer comprising a material based on a transition metal.

7. The process of producing a thin-film sensor according to claim 6, wherein the thin-film sensor further comprises a silicon compound layer between the insulating substrate and the adhesion layer, the silicon compound layer comprising a compound comprising silicon and an element selected from the group consisting of carbon, nitrogen, fluorine and oxygen.

8. The process of producing a thin-film sensor according to any one of claims 1 to 7, wherein the thin-film sensor is a sensor selected from the group consisting of a temperature sensor, a flow sensor, a specific heat sensor, a thermal conductivity sensor, a concentration sensor, a liquid identification sensor, a strain sensor, a stress sensor and a humidity sensor.

9. A thin-film sensor manufactured by the process of any one of claims 1 to 8.

10. A thin-film sensor module comprising the thin-film sensor of claim 9.

[Fig.1]

[Fig.2]

[Fig.3]

[Fig.4]

（A）　　　　（B）

<div align="center">

**INTERNATIONAL SEARCH REPORT**

</div>

| | International application No. |
|---|---|
| | PCT/JP2007/056589 |

A. CLASSIFICATION OF SUBJECT MATTER
*H01C7/02*(2006.01)i, *C23C14/14*(2006.01)i, *C23C14/34*(2006.01)i, *H01L37/00*
(2006.01)i

According to International Patent Classification (IPC) or to both national classification and IPC

B. FIELDS SEARCHED

Minimum documentation searched (classification system followed by classification symbols)
H01C7/02, C23C14/14, C23C14/34, H01L37/00

Documentation searched other than minimum documentation to the extent that such documents are included in the fields searched
Jitsuyo Shinan Koho      1922-1996   Jitsuyo Shinan Toroku Koho   1996-2007
Kokai Jitsuyo Shinan Koho   1971-2007   Toroku Jitsuyo Shinan Koho   1994-2007

Electronic data base consulted during the international search (name of data base and, where practicable, search terms used)
JST7580(JDream2), JSTPlus(JDream2)

C. DOCUMENTS CONSIDERED TO BE RELEVANT

| Category* | Citation of document, with indication, where appropriate, of the relevant passages | Relevant to claim No. |
|---|---|---|
| Y | JP 2001-012982 A  (Mitsui Mining & Smelting Co., Ltd.), <br> 19 January, 2001 (19.01.01), <br> Full text; all drawings <br> (Family: none) | 1-10 |
| Y | JP 02-226017 A  (Honeywell Inc.), <br> 07 September, 1990 (07.09.90), <br> Full text; all drawings <br> & US 4705713 A1        & DE 3603757 A | 1-10 |
| Y | J. Shi,D. Kojima,and M. Hashimoto, The interaction between platinum films and silicon substrates:Effects of substrate bias during sputtering deposition in:, JOURNAL OF APPLIED PHYSICS VOLUME 88, NUMBER 3 P1679-1683, 2000. 08.01, ISSN:0021-8979 | 1-10 |

| ☒ | Further documents are listed in the continuation of Box C. | ☐ | See patent family annex. |
|---|---|---|---|

| | | | |
|---|---|---|---|
| * | Special categories of cited documents: | "T" | later document published after the international filing date or priority date and not in conflict with the application but cited to understand the principle or theory underlying the invention |
| "A" | document defining the general state of the art which is not considered   to be of particular relevance | | |
| "E" | earlier application or patent but published on or after the international filing date | "X" | document of particular relevance; the claimed invention cannot be considered novel or cannot be considered to involve an inventive step when the document is taken alone |
| "L" | document which may throw doubts on priority claim(s) or which is cited to establish the publication date of another citation or other special reason (as specified) | "Y" | document of particular relevance; the claimed invention cannot be considered to involve an inventive step when the document is combined with one or more other such documents, such combination being obvious to a person skilled in the art |
| "O" | document referring to an oral disclosure, use, exhibition or other means | | |
| "P" | document published prior to the international filing date but later than the priority date claimed | "&" | document member of the same patent family |

| Date of the actual completion of the international search | Date of mailing of the international search report |
|---|---|
| 22 June, 2007 (22.06.07) | 03 July, 2007 (03.07.07) |

| Name and mailing address of the ISA/ | Authorized officer |
|---|---|
| Japanese Patent Office | |
| Facsimile No. | Telephone No. |

Form PCT/ISA/210 (second sheet) (April 2005)

**EP 2 009 647 A1**

<table>
<tr><td colspan="2"><strong>INTERNATIONAL SEARCH REPORT</strong></td><td>International application No.<br>PCT/JP2007/056589</td></tr>
</table>

| C (Continuation). DOCUMENTS CONSIDERED TO BE RELEVANT | | |
|---|---|---|
| Category* | Citation of document, with indication, where appropriate, of the relevant passages | Relevant to claim No. |
| A | JP 01-176316 A (NEC Corp.),<br>12 July, 1989 (12.07.89),<br>Full text; all drawings<br>(Family: none) | 1-10 |
| A | JP 2001-091321 A (Mitsui Mining & Smelting Co., Ltd.),<br>06 April, 2001 (06.04.01),<br>Par. Nos. [0022] to [0025]; Figs. 3, 4<br>& WO 00/079221 A1    & US 6672154 B1<br>& EP 1193477 A1 | 1-10 |

Form PCT/ISA/210 (continuation of second sheet) (April 2005)

15

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2001291607 A

- JP H11354302 A

**Non-patent literature cited in the description**

- HAKUMAKU, BIRYUUSHI NO KOUZOU TO BUS-SEI. MARUZEN, 1974, 139-156

- KOU TCR HAKKIN HAKUMAKU NO KAIHATSU. *IEEE Trans. SM.,* 2004, vol. 124 (7), 242-247